# EUROPEAN PATENT APPLICATION

(11) **EP 2 704 130 A1**
(43) Date of publication of application: **05.03.2014**
(21) Application number: 12777834.8
(22) Date of filing: 15.02.2012
(51) Int. Cl.: G09F 9/30, H01L 27/32, H01L 51/50, H05B 33/10, H05B 33/22

(54) **ORGANIC LIGHT-EMITTING ELEMENT, PRODUCTION METHOD FOR ORGANIC LIGHT-EMITTING ELEMENT, DISPLAY DEVICE, AND ILLUMINATION DEVICE**

(30) Priority: 28.04.2011 JP 2011101523
(71) Applicant: Showa Denko K.K., Tokyo 105-8518 (JP)
(72) Inventor: SAKO, Kanjiro, Tokyo 105-8518 (JP); MASUYA, Kyousuke, Tokyo 105-8518 (JP); TAJIMA, Masaru, Tokyo 105-8518 (JP); HIROSE, Katsumasa, Tokyo 105-8518 (JP)
(74) Representative: Strehl Schübel-Hopf & Partner
(86) International application number: PCT/JP2012/053486
(87) International publication number: WO 2012/147390

(57) **Abstract**

An organic light-emitting element having a high light extraction efficiency and a high light emission efficiency is provided, by an organic light-emitting element (10) including: an anode layer (12) formed on a substrate (11); a dielectric layer (13) formed on the anode layer (12); plural first recessed sections (16) formed by penetrating at least the dielectric layer (13); plural second recessed sections (17) formed on the upper surface of the dielectric layer (13) without penetrating the dielectric layer (13); an organic compound layer (14) including a light emitting layer formed to cover at least the upper surface of the dielectric layer (13), the inner surface of the first recessed sections (16) and the inner surface of the second recessed sections (17); and a cathode layer (15) formed on the organic compound layer (14).

## Description

### Technical Field

The present invention relates to an organic light-emitting element or the like used for, for example, a display device or an illumination device.

### Background Art

For example, an organic light-emitting element using an organic compound as a light-emitting body is expected to be applied for illumination purpose because of the characteristics of surface light source thereof, and technologies on extracting the emitted light toward outside are actively developed for the purpose of further high-efficiency.

Patent Document 1 discloses an organic light-emitting element in which a cavity penetrating an electrode and a dielectric layer is formed in a laminated structure of the electrode and the dielectric layer and a light emitting layer is formed in the cavity.

Patent Document 2 discloses a technology in which a two-dimensional diffraction granting composed of two kinds of medium having different refractive indices is provided on a light extracting side of a light emitting layer, thereby light extraction efficiency is improved.

### Citation List

### Patent Literature

Patent Document 1: Japanese Patent Application Unexamined Publication (Translation of PCT Application) No. 2010-509729
Patent Document 2: Japanese Patent Application Laid-Open Publication No. 2006-114432

### Disclosure of Invention

### Technical Problem

In a conventional organic light-emitting element formed by laminating an electrode and a light emitting layer on a transparent substrate, there has been a problem that a part of light emitted from the light emitting layer is reflected at an interface of layers having different refractive indices and confined inside of the light emitting layer, thereby light extraction effect is not sufficient.

### Solution to Problem

To address the above problem, the present inventors have found that, by forming recessed portions penetrating the dielectric layer and recessed portions not penetrating the dielectric layer on the dielectric layer formed on the electrode, the light emission efficiency of an organic light-emitting element is improved even if the number of the recessed portions where current flows is small, and completed the invention. That is, the present invention is summarized as follows.

An organic light-emitting element according to the present invention includes; a first electrode that is formed on a substrate; a dielectric layer that is formed on the first electrode; plural first recessed portions that are formed to penetrate at least the dielectric layer; plural second recessed portions that are formed on an upper surface of the dielectric layer not to penetrate the dielectric layer; an organic compound layer that includes a light emitting layer formed to cover at least the upper surface of the dielectric layer, an inner surface of the first recessed portions and an inner surface of the second recessed portions; and a second electrode that is formed on the organic compound layer.

Here, the first recessed portions are preferably formed so as to reach the first electrode, and formed to penetrate or not to penetrate the first electrode, and a refractive index of the dielectric layer is preferably lower than both a refractive index of the first electrode and a refractive index of the organic compound layer.

Moreover, the first recessed portions and the second recessed portions preferably have a circular shape or a polygonal shape with the maximum width of 10 µm or less in an area surface of the dielectric layer, and the first recessed portions and the second recessed portions are preferably formed 10³ to 10⁸ per 1 mm square in an arbitrary area surface of the dielectric layer, and the first recessed portions and the second recessed portions are preferably formed so that the number of the second recessed portions are twice or more the number of the first recessed portions at an arbitrary 1 mm square of the area surface of the dielectric layer.

Production method for an organic light-emitting element according to the present invention includes; a laminating process in which a first electrode and a dielectric layer are laminated on a substrate in order; a first recessed portion forming process in which plural first recessed portions are formed to penetrate the dielectric layer; a second recessed portion forming process in which plural second recessed portions are formed on an upper surface of the dielectric layer not to penetrate the dielectric layer; an organic compound layer forming process in which an organic compound layer that includes a light emitting layer formed to cover at least the upper surface of the dielectric layer, an inner surface of the first recessed portions and an inner surface of the second recessed portions is formed; and a second electrode forming process in which a second electrode is formed on the organic compound layer.

A display device according to the present invention includes the organic light-emitting element described above.

An illumination device according to the present invention includes the organic light-emitting element described above.

### Advantageous Effects of Invention

According to the present invention, an organic light-emitting element that has high light extraction efficiency and high light emission efficiency can be provided.

### Brief Description of Drawings

FIG. 1 is a partial cross-sectional view for illustrating a first specific example of an organic light-emitting element to which the exemplary embodiment is applied;
FIG. 2 is a partial cross-sectional view for illustrating a second specific example of an organic light-emitting element to which the exemplary embodiment is applied;
FIGS. 3A to 3E are diagrams for illustrating the production method of the organic light-emitting element to which the exemplary embodiment is applied;
FIG. 4 is a diagram for illustrating an example of a display device using the organic light-emitting element according to the exemplary embodiment;
FIG. 5 is a diagram for illustrating an example of an illumination device having the organic light-emitting element according to the exemplary embodiment;
FIG. 6A is a diagram for illustrating an example of an arrangement of the first recessed portions and the second recessed portions of Examples 1 to 3; and
FIG. 6B is a diagram for illustrating an example of an arrangement of the first recessed portions and the second recessed portions of Example 4.

### Description of Embodiments

There is a case where a part of light emitted from a light emitting layer goes into a gap between an upper surface of a dielectric layer and an electrode on the light emitting layer. In this case, in that space, the light is repeatedly reflected, confined inside, and difficult to be emitted to outside. Thereby light usage efficiency is lowered, and light emission efficiency of an organic light-emitting element is lowered.

Therefore, the organic light-emitting element of the present exemplary embodiment promotes to suppress the problem by adopting the embodiment described below.

### (First embodiment of organic light-emitting element)

Hereinafter, an exemplary embodiment of the present invention will be described in detail with reference to the attached drawings.

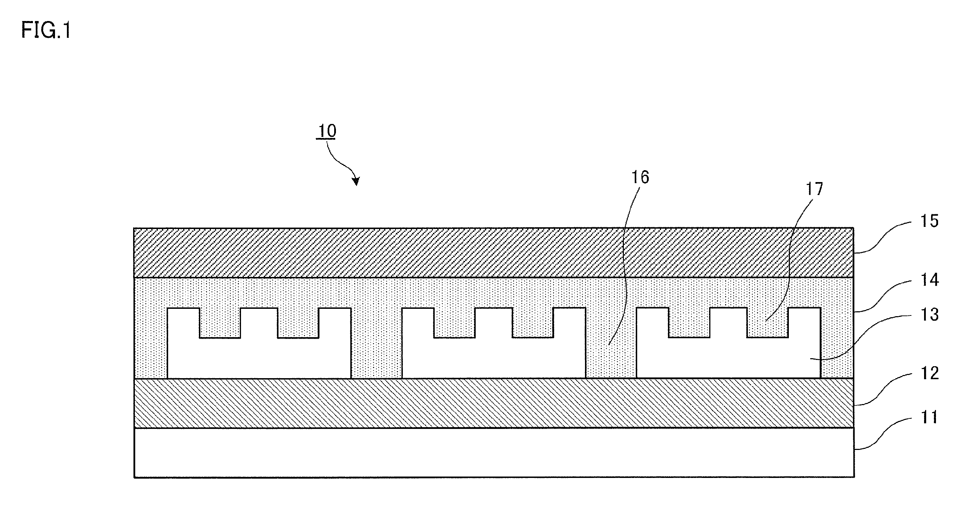

FIG. 1 is a partial cross-sectional view for illustrating a first specific example of an organic light-emitting element to which the exemplary embodiment is applied.

An organic light-emitting element 10 shown in FIG. 1 has a configuration in which a substrate 11, an anode layer 12 as a first electrode for injecting holes, which is formed on the substrate 11 in a case where the substrate 11 side is assumed to be the downside, a cathode layer 15 as a second electrode for injecting electrons, and a dielectric layer 13 formed between the anode layer 12 and the cathode layer 15 are stacked. The dielectric layer 13 includes; plural first recessed portions 16 formed to penetrate the dielectric layer 13; and plural second recessed portions 17 formed not to penetrate the dielectric layer 13. Further, the organic light-emitting element 10 has an organic compound layer 14 that includes a light emitting layer that emits light with application of voltage and is formed to cover at least the upper surface of the dielectric layer 13, an inner surface of the first recessed portions 16 and an inner surface of the second recessed portions 17. In the present exemplary embodiment, the organic compound layer 14 is composed of a single layer, the organic compound layer 14 is the light emitting layer. As the organic compound layer 14 emits light, a light emitting surface of the organic light-emitting element 10 is formed. In the present exemplary embodiment, the organic compound layer 14 and the cathode layer 15 are successively formed on a whole surface of the light emitting surface.

The substrate 11 is a base material that serves as a support body for forming the anode layer 12, the dielectric layer 13, the organic compound layer 14 and the cathode layer 15. For the substrate 11, a material that satisfies mechanical strength required for the organic light-emitting element 10 is used.

In the case where the light is to be taken out from the substrate 11 side of the organic light-emitting element 10, the material for the substrate 11 is required to be transparent to the light emitted from the light emitting layer. Specific examples include: glasses such as sapphire glass, soda glass and quartz glass; transparent resins such as acrylic resins, methacrylic resins, polycarbonate resins, polyester resins and nylon resins; silicon resins; and transparent metallic oxide such as aluminum nitride and alumina. In a case of using, as the substrate 11, a resin film or the like made of the aforementioned transparent resins, it is preferable that permeability to gas such as moisture and oxygen is low. In a case of using a resin film or the like having high permeability to gas, a thin film having a barrier property for inhibiting permeation of gas is preferably formed as long as the light transmission is not lost.

In a case where it is unnecessary to take out the light from the substrate 11 side of the organic light-emitting element 10, the material of the substrate 11 is not limited to the ones which are transparent to the visible light, and may be opaque to the visible light. The specific examples of the material of the substrate 11 include: in addition to the above-described materials, a simple substances such as silicon (Si), copper (Cu), silver (Ag), gold (Au), platinum (Pt), tungsten (W), titanium (Ti), tantalum (Ta) or niobium (Nb); alloys thereof; or stainless steel. The specific examples of the material of the substrate 11 also include oxides such as SiO₂ Al₂O₃ and the like; and a semiconductor material such as n-Si and the like.

Although the thickness of the substrate 11 depends on the required mechanical strength, it is preferably 0.1 mm to 10 mm, and more preferably 0.25 mm to 2 mm.

Voltage is applied between the anode layer 12 and the cathode layer 15, and holes are injected from the anode layer 12 to the organic compound layer 14. The anode layer 12 is preferably formed to be a planar shape along the substrate 11 surface, and to be a flat surface without having fine asperities on an upper surface thereof as much as possible. Materials used for the anode layer 12 are necessary to have electric conductivity. Specifically, it is preferable that the materials have high work function and the work function is not less than 4.5 eV. In addition, it is preferable that the electric resistance is not notably changed for an alkaline aqueous solution.

As the materials satisfying such requirements, metal oxides, metals or alloys can be used. As the metal oxides, indium tin oxide (ITO) and indium zinc oxide (IZO) are provided, for example. As the metals, provided are: copper (Cu); silver (Ag); gold (Au); platinum (Pt); tungsten (W); titanium (Ti); tantalum (Ta); niobium (Nb) and the like. Further, alloys such as stainless steel including these metals can be used. The thickness of the anode layer 12 is formed to be, for example, 2 nm to 2 µm. Note that, the work function can be measured by, for example, an ultraviolet photoelectron spectroscopy.

The dielectric layer 13 refracts the light emitted from the organic compound layer 14, so that the light easily enters into the substrate 11. Thus, a refractive index of the dielectric layer 13 is preferably lower than both a refractive index of the anode layer 12 and a refractive index of the organic compound layer 14. In the exemplary embodiment, the refractive index of the dielectric layer 13 is lower than that of the organic compound layer 14. Therefore, the light emitted from the organic compound layer 14 is refracted at an angle closer to the normal direction of the substrate 11 when the light enters into the dielectric layer 13. As a result, compared to a case in which the dielectric layer 13 is not provided, total reflection of the light having reached the anode layer 12 or the substrate 11 is not likely to occur at an interface between the dielectric layer 13 and the anode layer 12 and at an interface between the anode layer 12 and the substrate 11. Accordingly, the light easily enters into the anode layer 12 or the substrate 11. In other words, by providing the dielectric layer 13, the light emitted from the organic compound layer 14 can be extracted more from a substrate 11 side, thereby the light extraction efficiency is improved.

In the exemplary embodiment, the dielectric layer 13 has insulating properties. By having insulating properties, the dielectric layer 13 can separate the anode layer 12 from the cathode layer 15 with a predetermined gap therebetween and insulate them, while making light emitting materials included in the organic compound layer 14 emit light by applying voltage between the anode layer 12 and the cathode layer 15. Thus, the dielectric layer 13 is required to be made of materials having high resistivity, and the electric resistivity thereof is required to be not less than 10⁸ Ωcm, and preferably not less than 10¹² Ωcm. Specific examples of the materials include: metal nitrides such as silicon nitride, boron nitride and aluminum nitride; metal oxides such as silicon oxide (silicon dioxide) and aluminum oxide; and metal fluorides such as sodium fluoride, lithium fluoride, magnesium fluoride, calcium fluoride and barium fluoride; and in addition, polymer compounds such as polyimide, polyvinylidene fluoride and parylene; and spin-on glasses (SOG) such as poly (phenylsilsesquioxane) can be used. The light extraction efficiency is especially improved when the refractive index of the dielectric layer 13 is lower than both the refractive index of the anode layer 12 and the refractive index of the organic compound layer 14. Therefore, as materials for forming the dielectric layer 13, it is preferable to select materials having a refractive index lower than that of materials for forming the anode layer 12 and the organic compound layer 14.

Here, in order to manufacture, with high reproducibility, the organic light-emitting element 10 that is less likely to be short-circuited and less likely to leak a current, it is preferable that the thickness of the dielectric layer 13 is thicker. On the other hand, the thickness of the dielectric layer 13 is preferably not more than 1 µm in order to suppress the entire thickness of the organic light-emitting element 10. In addition, since the voltage necessary to emit light is lower as the distance between the anode layer 12 and the cathode layer 15 is shorter, the dielectric layer 13 is preferably set to be thin from this viewpoint. However, if it is too thin, dielectric strength becomes possibly insufficient against the voltage for driving the organic light-emitting element 10. Here, the dielectric strength is preferably not more than 0.1 mA/cm² in current density of a current passing between the anode layer 12 and the cathode layer 15 in the state where the organic compound layer 14 is not formed, and more preferably not more than 0.01 mA/cm². Further, since the dielectric layer 13 preferably endures the voltage more than 2V for the driving voltage of the organic light-emitting element 10, for example, in the case where the driving voltage is 5V, the aforementioned current density is necessary to be achieved when the voltage of about 7V is applied between an anode electrode and a cathode electrode that are formed to contact with both surfaces of the dielectric layer 13. The thickness of the dielectric layer 13 that satisfies these requirements is preferably not more than 750 nm as the upper limit, more preferably not more than 400 nm, and still more preferably not more than 200 nm. The thickness of the dielectric layer 13 is preferably not less than 15 nm as the lower limit, more preferably not less than 30 nm, and still more preferably not less than 50 nm.

The organic compound layer 14 is composed of a single or laminated plural layers including a light emitting layer and composed of an organic compound, and formed to cover at least the upper surface of the dielectric layer 13, an inner surface of the first recessed portions 16 and an inner surface of the second recessed portions 17. That is, the organic compound layer 14 is successively formed on a whole surface of the light emitting surface. The light emitting layer includes a light emitting material that emits light when the voltage is applied between the anode layer 12 and the cathode layer 15. As the light emitting material, either low-molecular compound or high-molecular compound may be used. In the present exemplary embodiment, as a light emitting material, it is preferable to use phosphorescent organic compounds as a light-emitting organic material and metal complexes. Among the metal complexes, there exist ones that show phosphorescence, and such metal complexes are also preferably used. In the present exemplary embodiment, in particular, it is exceptionally desirable to use cyclometalated complexes in terms of improving light emission efficiency. As the cyclometalated complexes, complexes of Ir, Pd, Pt and the like including ligands such as 2-phenylpyridine derivatives, 7, 8-benzoquinoline derivatives, 2-(2-thienyl)pyridine derivatives, 2-(1-naphthyl)pyridine derivatives, 2-phenylquinoline derivatives are provided, and iridium (Ir) complexes are especially preferred. The cyclometalated complexes may include ligands other than the ligands required to form the cyclometalated complexes. Note that the cyclometalated complexes are preferable in terms of improving light emission efficiency because compounds that emit light from triplet exciton are included therein.

Moreover, specific examples of light-emitting polymer compounds include: poly-p-phenylenevinylene (PPV) derivatives such as MEH-PPV (poly[2-methoxy-5-(2-ethylhexyloxy)-1,4-phenykenevinylene]); polymer compounds of a n-conjugated system such as polyfluorene derivatives and polythiophene derivatives; polymers introducing low-molecular pigments and tetraphenyldiamine or triphenylamine to a main chain or a side chain and the like. The light-emitting polymer compounds and light-emitting low-molecular compounds can be used in combination.

The light emitting layer includes the light-emitting material and a host material, and the light emitting material is dispersed in the host material in some cases. It is preferable that the host material has charge transporting properties, and it is also preferable that the host material is a hole-transporting compound or an electron-transporting compound.

The organic compound layer 14 may include a hole-transporting layer to receive a hole from the anode layer 12 and transport the hole to the light emitting layer. The hole-transporting layer is provided between the anode layer 12 and the light emitting layer.

As the hole-transporting materials for forming the hole-transporting layer, publicly known materials can be used, and examples thereof include low molecular triphenylamine derivatives such as: TPD (N,N'-diphenyl-N,N'-bis(3-methylphenyl)-1,1'-biphenyl-4,4'diamine)α-NPD (4,4'-bis[N-(1-naphthyl)-N-phenylamino]biphenyl); and m-MTDATA (4,4',4"-tris(3-methylphenylphenylamino)triphenylamine). In addition, examples also include: polyvinylcarbazole; and triphenylamine derivative-based high-molecular compound polymerized by introducing a polymerizable functional group. The above hole-transporting materials may be used solely or by mixing two or more, and may be used by laminating different hole-transporting materials. The thickness of the hole-transporting layer depends on conductivity or the like of the hole-transporting layer, therefore it is not generally limited, however, it is preferably in the range of 1 nm to 5 µm, more preferably 5 nm to 1 µm, further preferably 10 nm to 500 nm.

To mediate a hole injection barrier, a hole injection layer may be provided between the above hole-transporting layer and the anode layer 12. As a material for forming the hole injection layer, publicly known materials such as copper phthalocyanine, a mixture of poly-ethylendioxythiophene (PEDOT) and polystyrene sulfonate (PSS) (PEDOT:PSS), fluorocarbon and silicon dioxide may be used, and a mixture of the hole-transporting materials used for the above hole-transporting layer and electron acceptors such as 2,3,5,6-tetrafluorotetracyano-1,4-benzoquinodimethane (F4TCNQ) may be used.

The above organic compound layer 14 may include an electron transporting layer for transporting an electron from the cathode layer 15 to the light emitting layer.

The material which can be used for the electron transporting layer includes; quinolinic derivatives, oxiadiazole derivatives, perylene derivatives, pyridine derivatives, pyrimidine derivatives, quinoxaline derivatives, diphenylquinone derivatives, nitro displacement fluorene derivatives or the like. More specifically, tris(8-quinolinolato)aluminium (abbreviated expression: Alq), bis[2-(2-hydroxyphenyl)benzooxazolato]zinc, bis[2-(2-hydroxyphenyl)benzothiazolato]zinc, 2-(4-biphenylyl)-5-(4-tert-butylphenyl)-1,3,4-oxadiazol can be used.

Moreover, for the purpose of suppressing holes from penetrating the light emitting layer and efficiently recombining holes and electrons in the light emitting layer, a hole-block layer may be provided between the above electron transporting layer and the light emitting layer. This hole-block layer may be considered as one of layers included in the organic compound layer 14.

In order to form the above hole-block layer, publicly known materials such as a triazine derivative, an oxadiazole derivative, a phenanthroline derivative or the like may be used.

The cathode layer 15 injects electrons into the organic compound layer 14 upon application of voltage between the anode layer 12 and the cathode layer 15. The cathode layer 15 is, as well as the organic compound layer 14, successively formed on a whole surface of the light emitting surface.

The material used for the cathode layer 15 is not particularly limited as long as, similarly to that of the anode layer 12, the material has electrical conductivity; however, it is preferable that the material has a low work function and is chemically stable. The specific examples of the material include Al, MgAg alloy and alloys of Al and alkali metals such as AlLi and AlCa. The thickness of the cathode layer 15 is preferably in the range of 10 nm to 1 µm, and more preferably 50 nm to 500 nm. In the organic light-emitting element 10 of the exemplary embodiment, light emitted from the organic compound layer 14 is extracted from the substrate 11 side. Therefore, the cathode layer 15 may be formed by an opaque material. Note that, if light is intended to be extracted from not only the substrate 11 side but also from the cathode layer 15 side, the cathode layer 15 is necessary to be made of a transparent material such as ITO.

To lower the barrier for the electron injection from the cathode layer 15 into the organic compound layer 14 and thereby to increase the electron injection efficiency, a cathode buffer layer that is not shown in the figure may be provided adjacent to the cathode layer 15.

Metallic materials having a lower work function than the cathode layer 15 may be used for the cathode buffer layer. For example, the material thereof includes alkali metals (Na, K, Rb and Cs), alkaline earth metals (Sr, Ba, Ca and Mg), rare earth metals (Pr, Sm, Eu and Yb), one selected from fluoride, chloride and oxide of these metals and mixture of two or more selected therefrom. The thickness of the cathode buffer layer is preferably in the range of 0.05 nm to 50 nm, more preferably 0.1 nm to 20 nm, and still more preferably 0.5 nm to 10 nm.

In the present exemplary embodiment, the dielectric layer 13 includes the plural first recessed portions 16 that are formed to penetrate the dielectric layer 13 and the plural second recessed portions 17 that are formed on the upper surface of the dielectric layer 13 not to penetrate the dielectric layer 13. Inner surfaces of the first recessed portions 16 and the second recessed portions 17 are covered with the organic compound layer 14, respectively, thereby the light emitted from the organic compound layer 14 can be efficiently extracted to outside toward the substrate 11 side and/or the cathode layer 15 side. Inside of the first recessed portions 16, holes necessary to emit light are injected from the anode layer 12 since the organic compound layer 14 is in contact with the anode layer 12, whereas, inside of the second recessed portions 17, holes are difficult to be directly injected into the organic compound layer 14 since the organic compound layer 14 is not in contact with the anode layer 12. However, even in the case, it becomes possible to inject holes into inside of the second recessed portions 17 by forming the hole injection layer, which is a layer with high electric conductivity as described above.

Here, the shape of the first recessed portion 16 is not particularly limited, however, for easily controlling the shape thereof, it is preferable that the shape of the recessed portion 16 is a cylindrical shape or a polygonal columnar shape such as square pole, for example. In these shapes, shape in an area surface of the dielectric layer 13 may be varied in the thickness direction of the dielectric layer 13, or size of the shape may be varied. That is, the shapes may be, for example, conic, pyramid, conic trapezoid, or pyramid trapezoid. By arbitrarily selecting the shape of the first recessed portion 16, it is possible to control light distribution or the like when the light emitted from the organic compound layer 14 is extracted outside.

In the partial cross-sectional view of FIG. 1, a side surface of the first recessed portions 16 is formed to be perpendicular to a surface of the substrate 11, and the inclined angle of the side surface of the first recessed portions 16 is 90 degrees, in this case. Note that the inclined angle is not limited thereto and may be appropriately changed according to the materials or the like used for the dielectric layer, thereby the light extraction efficiency with which the light emitted from the organic compound layer 14 is extracted toward outside can be improved. In the present exemplary embodiment, the inclined angle is preferably in the range of 60 degrees to 90 degrees, more preferably 75 degrees to 90 degrees, further preferably 80 degrees to 90 degrees.

Further, for setting the area of a conduction portion on the light emitting surface to be large and achieving high light emission efficiency, the size of the first recessed portions 16 on the dielectric layer 13 (the maximum width of a shape in the surface of the dielectric layer 13, in other words, the diameter of the minimum circle that encircles the shape) is preferably 10 µm or less. Moreover, from a view point of easy productivity, this size is preferably 0.1 µm or more, and more preferably 0.5 µm or more. Arrangement of the first recessed portions 16 on the dielectric layer 13 may be regular one such as square-lattice pattern or hexagonal-lattice pattern, or may be irregular one. This arrangement is arbitrarily selected from view points of wavelength of light emitted from the organic compound layer 14, light distribution emitted from the organic light-emitting element 10, or spectral control.

The shape, size and arrangement of the second recessed portions 17 are the same as those of the first recessed portions 16. The depth of the second recessed portions 17 is preferably in the range of 10 % to 90 % of the thickness of the dielectric layer 13, more preferably 20 % to 80 %, and the thickness of a part of the dielectric layer 13 where the second recessed portions 17 are formed preferably falls in a certain range of depth in which insulation property is maintained with respect to the application of driving voltage described above.

The first recessed portions 16 and the second recessed portions 17 are preferably formed 10³ to 10⁸ per 1 mm square in an arbitrary area surface of the dielectric layer 13. The first recessed portions 16 that contact with the anode layer 12 inside thereof are more likely to occur defects such as short-circuit than the second recessed portions 17, therefore the above number is preferably 10⁷ or less.

From view points of higher light extraction efficiency and lowering probability of occurrence of short-circuit, in an arbitrary surface of 1 mm square in the dielectric layer 13, the number rate of the first recessed portions 16 and the second recessed portions 17 is preferably set to be that (the number of the second recessed portions 17) / (the number of the first recessed portions 16) is three or more, and more preferably eight or more. That is, it is more preferable that the first recessed portions 16 and the second recessed portions 17 are formed so that the number of the second recessed portions 17 is three times or more the number of the first recessed portions 16 in an arbitrary area surface of 1 mm square in the dielectric layer 13.

### (Second embodiment of organic light-emitting element)

In the organic light-emitting element 10 described above in detail, the first recessed portions 16 reach the anode layer 12, however, the first recessed portions 16 do not penetrate the anode layer 12. Note that the configuration is not limited thereto, however, the first recessed portions 16 may be formed so as to reach the anode layer 12 and penetrate the anode layer 12.

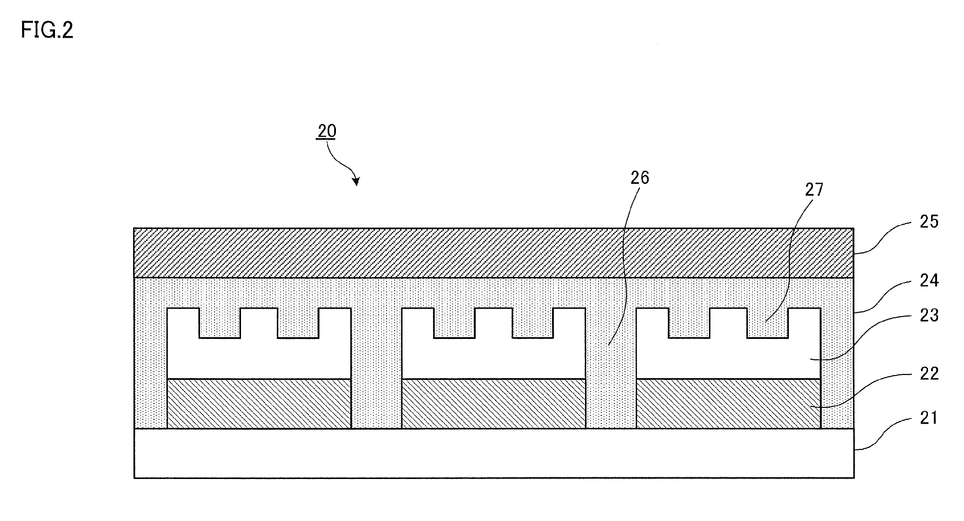

FIG. 2 is a partial cross-sectional view for illustrating a second specific example of an organic light-emitting element to which the exemplary embodiment is applied.

An organic light-emitting element 20 shown in FIG. 2 has a configuration in which a substrate 21, an anode layer 22 as a first electrode for injecting holes, which is formed on the substrate 21 in a case where the substrate 21 side is assumed to be the downside, a cathode layer 25 as a second electrode for injecting electrons, and a dielectric layer 23 formed between the anode layer 22 and the cathode layer 25 are stacked. The dielectric layer 23 includes; plural first recessed portions 26 formed to penetrate the dielectric layer 23; and plural second recessed portions 27 formed not to penetrate the dielectric layer 23. Further, the organic light-emitting element 20 has an organic compound layer 24 that includes a light emitting layer that emits light with application of voltage and is formed to cover at least the upper surface of the dielectric layer 23, an inner surface of the first recessed portions 26 and an inner surface of the second recessed portions 27. The organic compound layer 24 and the cathode layer 25 are successively formed on a whole surface of the light emitting surface. In the configuration described above, the organic light-emitting element 20 is the same as the organic light-emitting element 10 shown in FIG. 1. On the other hand, in the organic light-emitting element 20, the first recessed portions 26 are formed to penetrate not only the dielectric layer 23 but also the anode layer 22. Thus, even in a case where the anode layer 22 is composed of opaque materials, the light is able to be extracted from the substrate 21 side in the organic light-emitting element 20.

It should be noted that, in the organic light-emitting elements 10 and 20 described above in detail, in a case where the substrates 11 and 21 side are assumed to be the downside, a case where the anode layers 12 and 22 are formed downside and the cathode layers 15 and 25 are formed upside with the dielectric layers 13 and 23 interposed therebetween and facing each other is illustrated as a specific example, however, it is not limited thereto, and a configuration in which the anode layers 12 and 22 and the cathode layers 15 and 25 are replaced each other may be provided. That is, in a case where the substrates 11 and 21 side are assumed to be the downside, a configuration in which the cathode layers 15 and 25 are formed downside and the anode layers 12 and 22 are formed upside with the dielectric layers 13 and 23 interposed therebetween and facing each other may be provided.

### (Production method for organic light-emitting element)

Next, description will be given for a production method of the organic light-emitting element to which the exemplary embodiment is applied, while the organic light-emitting element 10 described with FIG. 1 is taken as an example.

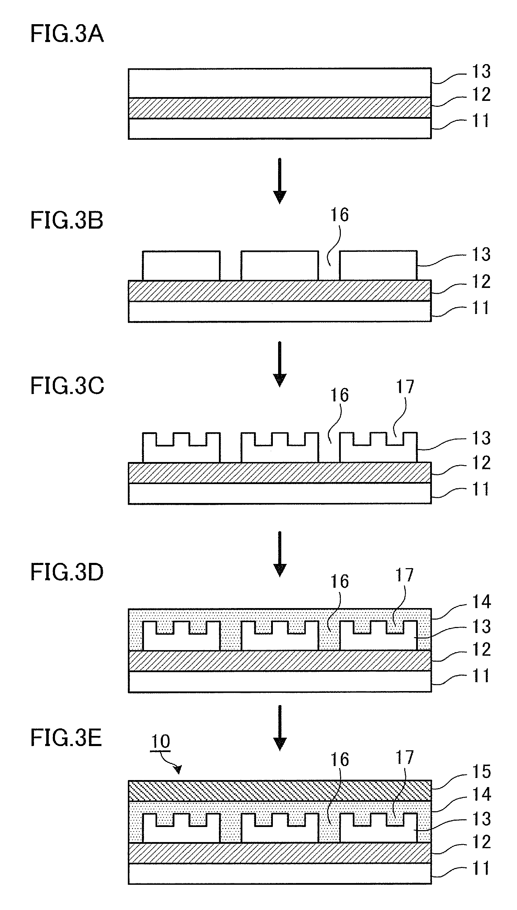

FIGS. 3A to 3E are diagrams for illustrating the production method of the organic light-emitting element 10 to which the exemplary embodiment is applied.

First, on the substrate 11, the anode layer 12 as a first electrode and the dielectric layer 13 are stacked and formed in order (FIG. 3A: laminating process). In the exemplary embodiment, a glass substrate is used as the substrate 11. Further, ITO is used as a material for forming the anode layer 12, and silicon dioxide (SiO₂) is used as a material for forming the dielectric layer 13.

For forming these layers on the substrate 11, a dry method such as; a resistance heating deposition method; an electron beam deposition method; a sputtering method; an ion plating method; and a CVD method or the like, and a wet method such as; a spin coating method; a dip coating method; an ink-jet printing method; a printing method; a spray-coating method; and a dispenser-printing method or the like may be used.

It should be noted that the process for forming the anode layer 12 can be omitted by using a so-called substrate with electrode in which ITO as the anode layer 12 has already been formed on the substrate 11.

Next, the first recessed portions 16 are formed so as to penetrate the dielectric layer 13 formed in the process of FIG. 3A (FIG. 3B: first recessed portion forming process).

Further, the second recessed portions 17 are formed on the dielectric layer 13 not to penetrate the dielectric layer 13 (FIG. 3C: second recessed portion forming process).

For forming the first recessed portions 16 and the second recessed portions 17 on the dielectric layer 13, a method using lithography may be used, for example. To form the first recessed portions 16 and the second recessed portions 17, first, a resist solution is applied on the dielectric layer 13 and then an excess resist solution is removed by spin coating or the like to form a resist layer. Thereafter, the resist layer is covered with a mask, in which a predetermined pattern for forming the first recessed portions 16 or the second recessed portions 17 is rendered, and is exposed with ultraviolet light (UV), an electron beam (EB) or the like. Then, the predetermined pattern corresponding to the first recessed portions 16 or the second recessed portions 17 is exposed onto the resist layer. Thereafter, light exposure portions of the resist layer are removed by use of a developing solution, exposed pattern portions of the resist layer are removed. By this process, the surface of the dielectric layer 13 is exposed so as to correspond to the exposed pattern portions.

Then, by using the remaining resist layer as a mask, exposed portions of the dielectric layer 13 are removed by etching. Either dry etching or wet etching may be used as the etching. Further, by combining isotropic etching and anisotropic etching at this time, the shape of the first recessed portions 16 or the second recessed portions 17 can be controlled. Reactive ion etching (RIE) or inductive coupling plasma etching is used as the dry etching, and a method of immersion in diluted hydrochloric acid, diluted sulfuric acid, or the like is used as the wet etching. Lastly, the residual resist layer is removed by using a resist removing solution, and the first recessed portions 16 or the second recessed portions 17 are formed on the dielectric layer 13. By performing the above patterning twice, the first recessed portions 16 and the second recessed portions 17 are formed on the dielectric layer 13, respectively. It should be noted that either first recessed portion forming process or second recessed portion forming process may be performed prior to the other.

Moreover, the first recessed portions 16 and the second recessed portions 17 can be formed by a method of nanoimprinting. Specifically, after forming the resist layer, a mask in which predetermined convex patterns to form a pattern are rendered is pressed against the surface of the resist layer with pressure. By applying heat and/or light to the resist layer in this state, the resist layer is cured. Next, the mask is removed, and thereby the pattern, which is a pattern of the first recessed portions 16 and the second recessed portions 17 corresponding to the convex patterns, is formed on a surface of the resist layer. The first recessed portions 16 and the second recessed portions 17 can be formed by subsequently performing the aforementioned etching.

For forming the first recessed portions 26 of the organic light-emitting element 20, the method same as that in forming the first recessed portions 16 of the organic light-emitting element 10 in FIG. 1 can be used. For example, the first recessed portions 26 may be formed by etching the dielectric layer 23 followed by further etching the anode layer 22. By differentiating the shape of the first recessed portions 26 in a portion of the dielectric layer 23 from the shape of the first recessed portions 26 in a portion of the anode layer 22, it is possible to control light distribution of light emitted from the organic light-emitting element 20 to outside.

After performing the first recessed portion forming process and the second recessed portion forming process, the organic compound layer 14 that includes a light emitting layer formed to cover at least the upper surface of the dielectric layer 13, an inner surface of the first recessed portions 16 and an inner surface of the second recessed portions 17 is formed (FIG. 3D: organic compound layer forming process).

For forming the organic compound layer 14, the method same as that in forming the anode layer 12 or the dielectric layer 13 can be used. It should be noted that formation of layers included in the organic compound layer 14 is preferably performed by a resistance heating deposition method or a coating method, and for forming a layer which includes macromolecular organic compounds, a coating method is especially preferable. When a layer is formed by a coating method, materials constituting the layer to be formed are applied to application liquid solution dispersed in a predetermined solvent such as an organic solvent or water. To perform coating, various methods such as a spin coating method, a spray coating method, a dip coating method, an ink-jet method, a slit coating method, a dispenser method and a printing method may be used. After the coating is performed, the light-emitting material solution is dried by heating or vacuuming, and thereby the layer to be formed is formed.

Next, the cathode layer 15 as a second electrode is formed on the organic compound layer 14 (FIG. 3E: second electrode forming process).

For forming the cathode layer 15, the method same as that in forming the anode layer 12 and the dielectric layer 13 can be used.

By the aforementioned processes, the organic light-emitting element 10 is manufactured.

Further, a protective layer or a protective cover (not shown) for stably using the organic light-emitting element 10 for long periods and protecting the organic light-emitting element 10 from outside may be mounted. As the protective layer, polymer compounds, metal oxides, metal fluorides, metal borides, or silicon compounds such as silicon nitrides and silicon oxides may be used. A lamination thereof may also be used. As the protective cover, glass plates, plastic plates with a surface treated with low hydraulic permeability, or metals may be used. The protective cover may be bonded to an element substrate by using a thermosetting resin or a photo-curable resin to be sealed. At this time, spacers may be used so that predetermined spaces are maintained, thus the prevention of scratches on the organic light-emitting element 10 is facilitated. Filling the spaces with inert gases such as nitrogen, argon and helium prevents the oxidation of the cathode layer 15 on the upper side. Especially, in a case of using helium, high thermal conductivity thereof enables heat generated from the organic light-emitting element 10 upon application of voltage to be effectively transmitted to the protective cover. In addition, by putting desiccants such as barium oxide in the spaces, the organic light-emitting element 10 is easily prevented from being damaged by moisture absorbed in the sequence of the aforementioned manufacturing processes.

The organic light-emitting element of the exemplary embodiment is preferably used for the display device as, for example, a pixel of matrix system or segment system. Further, the organic light-emitting element of the exemplary embodiment is also preferably used as a surface-emitting light source without forming a pixel. Specifically, the organic light-emitting element of the exemplary embodiment is preferably used as display devices in computers, televisions, mobile terminals, mobile phones, automobile navigation systems, traffic signs, advertising displays and viewfinders or the like of video cameras; and surface-emitting light sources in backlights, electrophotographics, illuminations, resist exposures, reading devices, interior illuminations, optical communication systems and the like.

### (Display device)

Next, description will be given for a display device having the aforementioned organic light-emitting element described in detail.

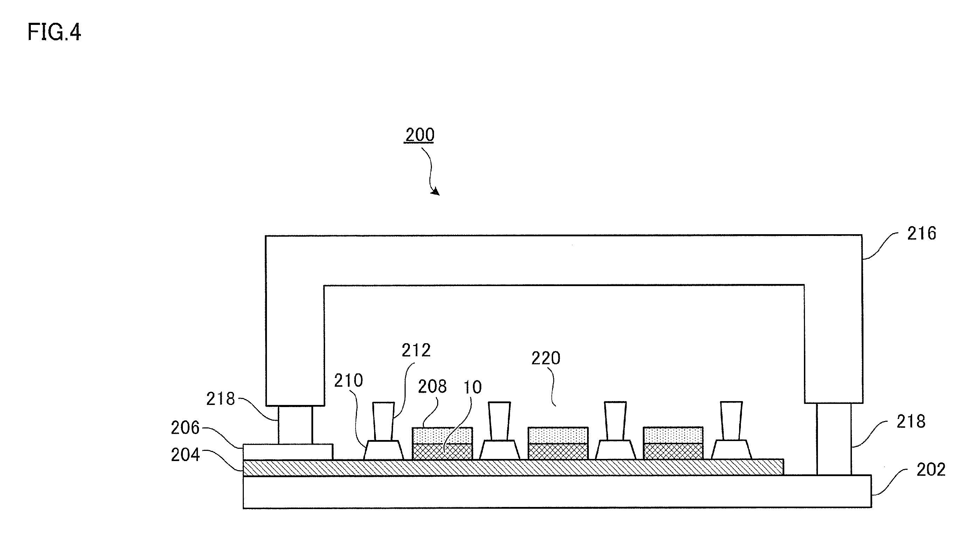

FIG. 4 is a diagram for illustrating an example of a display device using the organic light-emitting element 10 according to the exemplary embodiment.

A display device 200 shown in FIG. 4 is a so-called passive matrix display device, and is provided with a display device substrate 202, an anode wiring 204, an auxiliary anode wiring 206, a cathode wiring 208, an insulating film 210, a cathode partition 212, the organic light-emitting element 10, a sealing plate 216, and a sealant 218.

The display device substrate 202 may employ a transparent substrate such as a rectangular glass substrate. The thickness of the display device substrate 202 is not particularly limited; however, the thickness may be, for example, 0.1 mm to 1 mm.

On the display device substrate 202, plural anode wirings 204 are formed. The anode wirings 204 are arranged in parallel with certain intervals. The anode wiring 204 is configured with a transparent conductive film, and can be made of, for example, ITO (indium tin oxide). The thickness of the anode wiring 204 may be set to, for example, 100 nm to 150 nm. The auxiliary anode wiring 206 is formed on an end portion of each of the anode wirings 204. The auxiliary anode wiring 206 is electrically connected to the anode wiring 204. With such a configuration, the auxiliary anode wiring 206 functions as a terminal for connection to an external wiring on the end portion side of the display device substrate 202, and accordingly, a current is supplied from a not-shown drive circuit provided outside to the anode wirings 204 through the auxiliary anode wirings 206. The auxiliary anode wiring 206 may be configured with, for example, a metal film having a thickness of 500 nm to 600 nm.

Plural cathode wirings 208 are also provided on the organic light-emitting element 10. The plural cathode wirings 208 are arranged in parallel with each other, and each intersecting the anode wirings 204. Aluminum or aluminum alloy may be used for the cathode wiring 208. The thickness of the cathode wiring 208 is, for example, 100 nm to 150 nm. Further, similar to the auxiliary anode wiring 206 for the anode wirings 204, a not-shown auxiliary cathode wiring is provided on an end portion of each of the cathode wirings 208, and is electrically connected to the cathode wiring 208. Consequently, a current is capable of flowing between the cathode wirings 208 and the auxiliary cathode wirings.

On the display device substrate 202, the insulating film 210 is formed to cover the anode wirings 204. Opening portions 220 each having a rectangular shape are provided in the insulating film 210 to expose part of the anode wiring 204. The plural opening portions 220 are arranged in a matrix on the anode wirings 204. The organic light-emitting element 10 is provided at the opening portions 220 between the anode wirings 204 and the cathode wirings 208 as will be described later. In other words, each opening portion 220 becomes a pixel. Accordingly, a display region is formed corresponding to the opening portions 220. Here, the thickness of the insulating film 210 can be set to, for example, 200 nm to 300 nm, and the size of the opening portion 220 can be set to, for example, 300 µm square.

The organic light-emitting element 10 is formed at locations corresponding to the positions of the opening portions 220 on the anode wirings 204. The organic light-emitting element 10 is held between the anode wirings 204 and the cathode wirings 208 at the opening portion 220. In other words, the anode layer 12 and the cathode layer 15 of the organic light-emitting element 10 are in contact with the anode wirings 204 and the cathode wirings 208, respectively. The thickness of the organic light-emitting element 10 can be set to, for example, 150 nm to 200 nm.

On the insulating film 210, plural cathode partitions 212 are formed along the direction perpendicular to the anode wirings 204. The cathode partitions 212 play a role in spatially separating the plural cathode wirings 208 so that the cathode wirings 208 are not electrically connected to each other. Accordingly, each of the cathode wirings 208 is arranged between the adjacent cathode partitions 212. The size of the cathode partition 212 may be, for example, 2 µm to 3 µm in height and 10 µm in width.

The display device substrate 202 is bonded to the sealing plate 216 with the sealant 218. By this configuration, a space where the organic light-emitting element 10 is provided can be sealed, and thus the organic light-emitting element 10 can be prevented from deteriorating due to moisture in the air. As the sealing plate 216, for example, a glass substrate having a thickness of 0.7 mm to 1.1 mm can be used.

In the display device 200 with such a configuration, a current is supplied to the organic light-emitting element 10 via the auxiliary anode wirings 206 and the not-shown auxiliary cathode wirings from a not-shown driving device to cause the light emitting layer to emit light. By controlling light emission and non-light emission of the organic light-emitting element 10 corresponding to the aforementioned pixels with a controller, images can be displayed on the display device 200.

### (Illumination device)

Next, description will be given of an illumination device using the organic light-emitting element 10.

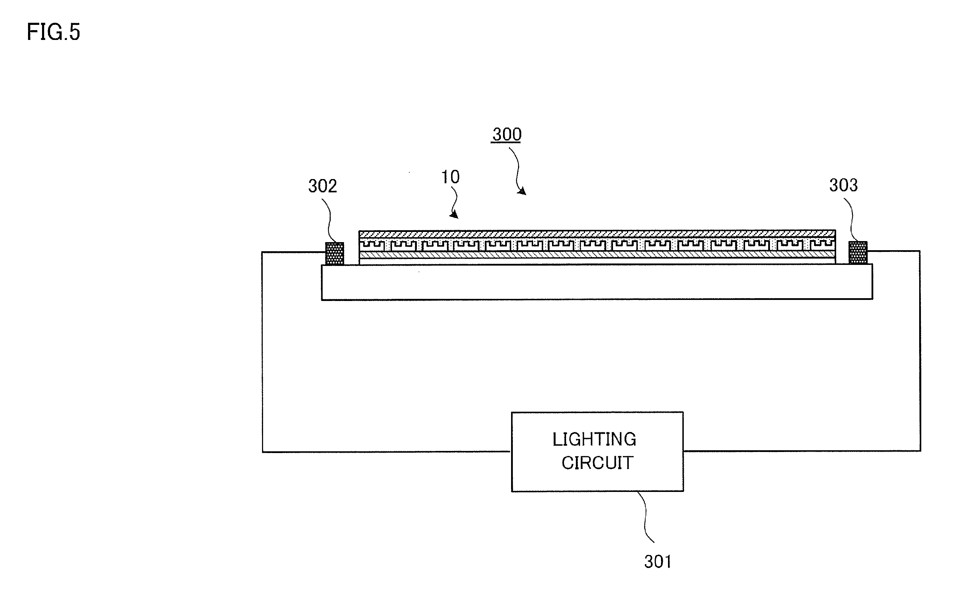

FIG. 5 is a diagram for illustrating a specific example of an illumination device having the organic light-emitting element 10 in the exemplary embodiment.

An illumination device 300 shown in FIG. 5 is configured with: the aforementioned organic light-emitting element 10; a terminal 302 that is provided adjacent to the substrate 11 (refer to FIG. 1) of the organic light-emitting element 10 and is connected to the anode layer 12 (refer to FIG. 1); a terminal 303 that is provided adjacent to the substrate 11 (refer to FIG. 1) and is connected to the cathode layer 15 (refer to FIG. 1) of the organic light-emitting element 10; and a lighting circuit 301 that is connected to the terminals 302 and 303 to drive the organic light-emitting element 10.

The lighting circuit 301 has a not-shown DC power supply and a not-shown control circuit inside thereof, and supplies a current between the anode layer 12 and the cathode layer 15 of the organic light-emitting element 10 via the terminals 302 and 303. The lighting circuit 301 drives the organic light-emitting element 10 to cause the light emitting layer to emit light, the light is outputted through the substrate 11, and the light is utilized for illumination. The light emitting layer may be configured with the light-emitting material that emits white light, or, it may be possible to provide plural organic light-emitting elements 10 using a light-emitting material that outputs each of the green light (G), blue light (B) and red light (R), thus making a synthetic light white. Note that, in the illumination device 300 according to the exemplary embodiment, when the light emission is performed with small diameter of the first recessed portions 16 (refer to FIG. 1) and small intervals between the first recessed portions 16, the light emission seems to be surface emitting to the human eyes.

### Examples

### [Preparation of light-emitting material solution]

A phosphorescent light-emitting polymer compound (A) was prepared in accordance with the method disclosed in International Publication No. WO2010-016512. The weight-average molecular weight of polymer compound (A) was 52000, and molar ratio of each repeating unit wask:m:n=6:42:52.

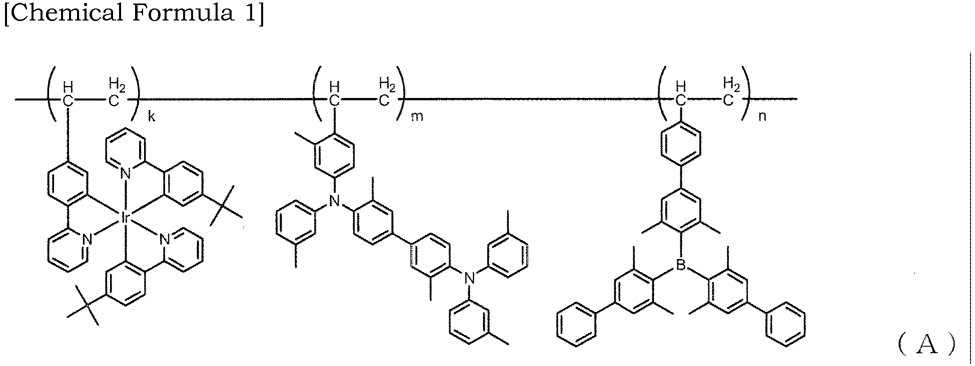

A light-emitting material solution (hereinafter, also referred to as "solution A") was prepared by dissolving 3 parts by weight of the light-emitting polymer compound prepared (A) in 97 parts by weight of toluene.

### [Preparation of organic light-emitting element]

### (Example 1)

As an organic light-emitting element, the organic light-emitting element 10 shown in FIG. 1 was produced by the method described below.

First, as the substrate 11, on a glass substrate made of fused quartz (25 mm per side, a thickness of 1mm), an ITO (indium tin oxide) film of 150 nm in thickness as the anode layer 12 and a silicon dioxide (SiO₂) layer of 50 nm in thickness as the dielectric layer 13 were formed by successive lamination with a sputtering device (E-401s manufactured by Canon ANELVA Corporation).

Next, a photoresist (AZ1500 manufactured by AZ Electronic Materials) of about 1 µm in thickness was formed by a spin coating method. Then, on a quartz (having a thickness of 3 mm) as a substrate, a mask A corresponding to a pattern in which circles are arranged in a triangular lattice was produced, and exposure was performed on a scale of 1 / 5 by use of a stepper exposure device (NSR-1505i6 manufactured by Nikon Corporation). Next, development was executed with 1.2% aqueous solution of TMAH (tetramethyl ammonium hydroxide: (CH₃)₄NOH) for patterning the resist layer. Thereafter, heat at a temperature of 130°C was applied for 10 minutes (post-baking process).

Next, by use of a reactive ion etching device (RIE-200iP manufactured by SAMCO Inc.), dry etching process was performed by causing a reaction for 18 minutes with CHF₃ as a reactant gas under conditions of a pressure of 0.3Pa and output bias/ICP = 50/100 (W). Then the plural second recessed portions 17 were formed on a surface of the SiO₂ layer by removing the residue of the resist by the resist removing solution. The second recessed portions 17 had a cylindrical shape with a diameter of 1 µm and a height of 25 nm, and were arranged in a hexagonal lattice with a 2-µm pitch (center-to-center distance) on an entire surface of the SiO₂ layer.

Next, a patterning was performed by the similar method as forming the above second recessed portions 17 except that the patterning was performed on a substrate with ITO having SiO₂ layer in which the second recessed portions 17 were formed, a mask B corresponding to the pattern of the first recessed portions 16 was used, and etching time was set to 8 minutes, thereby plural first recessed portions 16 penetrating through the SiO₂ layer were formed. These first recessed portions 16 were formed to have cylindrical shape with diameter of 1 µm and height of 50 nm, penetrate the anode layer 12, and be arranged in a hexagonal-lattice shape on a whole surface of the SiO₂ layer with a 4-µm pitch (center-to-center distance). At this time, the mask was arranged so that the center of circle of the first recessed portion 16 overlap with the center of circle of the second recessed portion 17. It is similar to the examples and comparative examples described below.

Next, a hole injection layer as one of the layers constituting the organic compound layer 14 was formed. The hole injection layer can be formed by applying an aqueous suspension (1.5% by mass in content) of a mixture of poly(3,4)-ethylendioxythiophene (PEDOT) and polystyrene sulfonate (PSS) (PEDOT:PSS = 1:6 in mass ratio) by the spin coating method (spin rate: 3000 rpm), and being left under a nitrogen atmosphere at the temperature of 140°C for an hour to be dried.

Next, the light emitting layer as one of the layers constituting the organic compound layer 14 was formed by applying the solution A by the spin coating method (spin rate: 3000 rpm), and being left under a nitrogen atmosphere at the temperature of 140°C for an hour to be dried.

Next, on the above-described organic compound layer 14, a layer of sodium fluoride (4 nm) as the cathode buffer layer and a layer of aluminum (130 nm) as the cathode layer 15 were formed in order by a deposition method to prepare the electroluminescent element.

### (Example 2)

The organic light-emitting element 20 shown in FIG. 2 was prepared in the same manner as Example 1 except that a dry etching process described below was added after the dry etching process in the first recessed portion 16 forming process of Example 1.

That is, after dry etching process of the example 1 in which the mask B was used, by changing reactant gas to a mixture gas of Cl₂ and SiCl₄, dry etching process was performed by causing a reaction for 8 minutes with the reactant gas under conditions of a pressure of 1Pa and output bias/ICP = 200/100 (W), thereby the first recessed portions 26 penetrating the SiO₂ layer and the ITO layer were formed.

### (Example 3)

The organic light-emitting element 20 shown in FIG. 2 was prepared in the same manner as Example 2 except that the hole injection layer was not formed.

### (Example 4)

The organic light-emitting element 10 shown in FIG. 1 was prepared in the same manner as Example 1 except that the second recessed portions 17 had a cylindrical shape with a diameter of 0.5 µm and a height of 25 nm and were arranged with a 1-µm pitch.

### (Example 5)

The organic light-emitting element 10 shown in FIG. 1 was prepared in the same manner as Example 1 except that the first recessed portions 16 were arranged with a 8-µm pitch.

### (Example 6)

The organic light-emitting element 20 shown in FIG. 2 was prepared in the same manner as Example 3 except that the first recessed portions 26 were arranged with a 6-µm pitch.

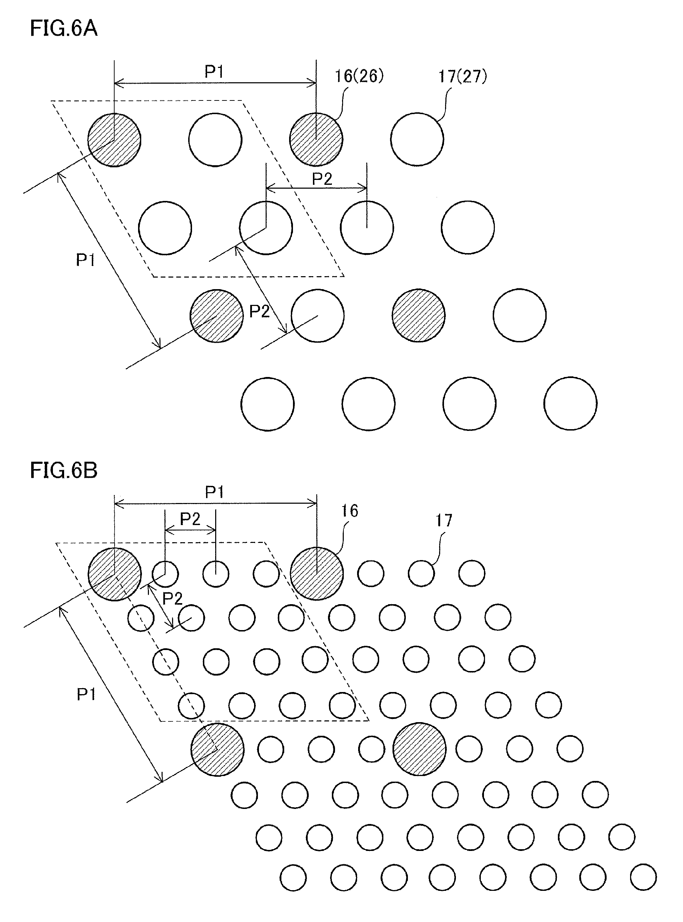

FIG. 6A is a diagram for illustrating an example of an arrangement of the first recessed portions 16, 26 and the second recessed portions 17, 27 of Examples 1 to 3. FIG. 6B is a diagram for illustrating an example of an arrangement of the first recessed portions 16 and the second recessed portions 17 of Example 4.

With reference to FIG. 6A, the pitch (P1) of the first recessed portions 16 (26) is set to be 4 µm, and the pitch (P2) of the second recessed portions 17 (27) is set to be 2 µm. As it is seen from an area surrounded by a dotted line, (the number of the second recessed portions) / (the number of the first recessed portions) is three. Similarly, with reference to FIG. 6B, the pitch (P1) of the first recessed portions 16 is set to be 4 µm, and the pitch (P2) of the second recessed portions 17 is set to be 1 µm. As it is seen from an area surrounded by a dotted line, (the number of the second recessed portions) / (the number of the first recessed portions) is fifteen.

### (Comparative Example 1)

An organic light-emitting element was prepared in the same manner as Example 1 except that the second recessed portions 17 were not formed.

### (Comparative Example 2)

An organic light-emitting element was prepared in the same manner as Example 2 except that the second recessed portions 27 were not formed.

### (Comparative Example 3)

An organic light-emitting element was prepared in the same manner as Comparative Example 2 except that the hole injection layer was not formed.

### (Comparative Example 4)

An organic light-emitting element was prepared in the same manner as Comparative Example 1 except that the first recessed portions 16 were arranged with a 2-µm pitch.

### (Comparative Example 5)

An organic light-emitting element was prepared in the same manner as Comparative Example 3 except that the first recessed portions 16 were arranged with a 2-µm pitch.

### [Evaluation Method]

Voltage was applied in a step-by-step manner to the organic light-emitting elements prepared in Examples 1 to 5 and Comparative Examples 1 to 3 by a DC power supply (SM2400 manufactured by Keithley Instruments Inc.), and light emitting intensity of the organic light-emitting elements was measured by a luminance meter (BM-9 manufactured by TOPCON CORPORATION). Then, light emission efficiency was determined by the rate of light emitting intensity with respect to the current density. Further, fifty organic light-emitting elements in Examples 1 to 5 and Comparative Examples 1 to 3 were prepared respectively, and unlikeliness of occurrence of short-circuit was evaluated by the number (number of defects) of the organic light-emitting elements which did not emit light even when current was applied with short-circuit.

### [Evaluation Result]

The results are shown in the Table 1 below. Regarding the light emission efficiency, the results mean that the light emission efficiency is better as the shown values are larger, and regarding the number of defects, the results mean that short-circuit is not more likely to occur and yield rate is more improved as the shown values are smaller.

**[Table 1]**

| | Penetration of anode layer | Pitch of first recessed portions (µm) | Pitch of second recessed portions (µm) | Number of second recessed portions) / Number of firsst recessed portions) | Hole injection layer | Light emission efficiency (cd/A) | Number of Defects |
|---|---|---|---|---|---|---|---|
| Example 1 | Not penetrate | 4 | 2 | 3 | Provided | 45 | 4 |
| Example 2 | Penetrate | 4 | 2 | 3 | Provided | 55 | 4 |
| Example 3 | Penetrate | 4 | 2 | 3 | Not provided | 40 | 6 |
| Example 4 | Not penetrate | 4 | 1 | 15 | Provided | 53 | 1 |
| Example 5 | Not penetrate | 8 | 2 | 15 | Provided | 57 | 1 |
| Example 6 | Penetrate | 6 | 2 | 8 | Not provided | 60 | 1 |
| Comparative Example 1 | Not penetrate | 4 | Second recessed portions are not provided | - | Provided | 33 | 9 |
| Comparative Example2 | Penetrate | 4 | Second recessed portions are not provided | - | Provided | 38 | 11 |
| Comparative Example3 | Penetrate | 4 | Second recessed portions are not provided | - | Not provided | 30 | 16 |
| Comparative Example4 | Not penetrate | 2 | Second recessed portions are not provided | - | Provided | 43 | 15 |
| Comparative Example5 | Penetrate | 2 | Second recessed portions are not provided | - | Not provided | 40 | 17 |

As seen from the Table 1, compared to Comparative Examples 1 to 3 in which the second recessed portions 17 and 27 are not provided, the Examples 1 to 6 in which the second recessed portions 17 and 27 are provided all have good results both in light emission efficiency and number of defects.

When Example 1 and Example 2 are compared to each other, the organic light-emitting element 20 in which the first recessed portions 16 penetrate the anode layer 12 has better result in light emission efficiency than the organic light-emitting element 10 in which the first recessed portions 16 do not penetrate the anode layer 12. Furthermore, when Example 2 and Example 3 are compared to each other, a case where the hole injection layer is provided has better results both in light emission efficiency and number of defects than a case where the hole injection layer is not provided. Still furthermore, when Examples 1, 4 and 5 are compared to each other, as the value of (the number of the second recessed portions) / (the number of the first recessed portions) is larger, light emission efficiency and number of defects are both better. The same explanation can be applied to the case where Example 3 and Example 6 are compared to each other.

In general, when the number of process such as process for extracting the light is increased, yield rate is likely to be lowered. However, although the reason is not known, the yield rate is not necessarily lowered in Examples 1 to 6 in which the forming process of the second recessed portions 17 is added, compared to Comparative Examples 1 to 5. As described above, in the present exemplary embodiment, it is possible to have the organic light-emitting elements good in light emission efficiency without lowering yield rate.

### Reference Signs List

- 10, 20: Organic light-emitting element
- 11, 21: Substrate
- 12, 22: Anode layer
- 13, 23: Dielectric layer
- 14,24.: Organic compound layer
- 15, 25: Cathode layer
- 16, 26: First recessed portions
- 17, 27: Second recessed portions
- 200: Display device
- 300: Illumination device

## Claims

1. An organic light-emitting element comprising:
a first electrode that is formed on a substrate;
a dielectric layer that is formed on the first electrode;
a plurality of first recessed portions that are formed to penetrate at least the dielectric layer;
a plurality of second recessed portions that are formed on an upper surface of the dielectric layer not to penetrate the dielectric layer;
an organic compound layer that includes a light emitting layer formed to cover at least the upper surface of the dielectric layer, an inner surface of the first recessed portions and an inner surface of the second recessed portions; and
a second electrode that is formed on the organic compound layer.

2. The organic light-emitting element according to claim 1, wherein the first recessed portions are formed so as to reach the first electrode, and formed to penetrate or not to penetrate the first electrode.

3. The organic light-emitting element according to any one of claims 1 and 2, wherein a refractive index of the dielectric layer is lower than both a refractive index of the first electrode and a refractive index of the organic compound layer.

4. The organic light-emitting element according to any one of claims 1 to 3, wherein
the first recessed portions and the second recessed portions have a circular shape or a polygonal shape with the maximum width of 10 µm or less in an area surface of the dielectric layer, and
the first recessed portions and the second recessed portions are formed 10³ to 10⁸ per 1 mm square in an arbitrary area surface of the dielectric layer.

5. The organic light-emitting element according to any one of claims 1 to 4, wherein the first recessed portions and the second recessed portions are formed so that the number of the second recessed portions are twice or more the number of the first recessed portions at an arbitrary 1 mm square of the area surface of the dielectric layer.

6. A production method for an organic light-emitting element comprising:
a laminating process in which a first electrode and a dielectric layer are laminated on a substrate in order;
a first recessed portion forming process in which a plurality of first recessed portions are formed to penetrate the dielectric layer;
a second recessed portion forming process in which a plurality of second recessed portions are formed on an upper surface of the dielectric layer not to penetrate the dielectric layer;
an organic compound layer forming process in which an organic compound layer that includes a light emitting layer formed to cover at least the upper surface of the dielectric layer, an inner surface of the first recessed portions and an inner surface of the second recessed portions is formed; and
a second electrode forming process in which a second electrode is formed on the organic compound layer.

7. A display device comprising the organic light-emitting element according to any one of claims 1 to 5.

8. An illumination device comprising the organic light-emitting element according to any one of claims 1 to 5.
